# EUROPÄISCHE PATENTSCHRIFT

(11) **EP 2 952 997 B1**
(45) Veröffentlichungstag und Bekanntmachung des Hinweises auf die Patenterteilung: **01.02.2017**
(21) Anmeldenummer: 14171500.3
(22) Anmeldetag: 06.06.2014
(51) Int. Cl.: G05F 7/00, H01F 27/38, H01F 27/33, H01F 27/42, H01F 29/14

(54) **Messanordnung zum Erfassen eines magnetischen Gleichflusses im Kern eines Transformators**
Measuring device for determination of a unidirectional magnetic flux in the core of a transformer
Dispositif de mesure destiné à l'enregistrement d'un flux magnétique continu dans le noyau d'un transformateur

(43) Veröffentlichungstag der Anmeldung: 09.12.2015
(73) Patentinhaber: Siemens Aktiengesellschaft, 80333 München (DE)
(72) Erfinder: Dr. Hamberger, Peter, 4202 Kirchschlag bei Linz (AT); Leber, Gerald, 8211 Großpesendorf (AT); Passath, Helfried, 8181 Unterfladnitz (AT); Pregartner, Helmut, 8160 Krottendorf (AT); Schrammel, Alfons-Karl, 8253 Waldbach (AT)
(74) Vertreter: Maier, Daniel Oliver

(56) Entgegenhaltungen:
- WO-A1-2011/127969
- US-A- 3 863 109
- US-A- 5 847 910
- US-A1- 2010 194 373

## Beschreibung

### Technisches Gebiet

Die Erfindung betrifft eine Messanordnung nach dem Oberbegriff von Anspruch 1.

### Stand der Technik

Bei elektrischen Transformatoren, wie sie in Energie-Verteilungsnetzen eingesetzt werden, kann es zur Ausbildung eines magnetischen Gleichflusses im Kern des Transformators kommen. Ursache für diesen magnetischen Gleichfluss kann ein Gleichstromanteil, auch als "DC-Anteil" bezeichnet, sein, der von leistungselektronischen Baukomponenten, wie sie beispielsweise im Zusammenhang mit elektrischen Antrieben oder mit Blindleistungskompensationsanlagen eingesetzt werden. Obwohl dieser Gleichstromanteil meist nur einige Promille des Transformator-Nennstroms ausmacht, verursacht er eine Verzerrung des Magnetisierungsstroms, der dann nicht mehr die Form eines Sinus aufweist. Infolge davon erhöhen sich die Temperatur im magnetischen Kern und auch die Temperatur der Wicklung. Ein weiterer unerwünschter Effekt ist eine erhöhte Geräuschentwicklung, was insbesondere dann als störend empfunden wird, wenn der Transformator in der Nähe eines Wohnbereichs installiert ist. Es sind aber auch andere Ursachen des magnetischen Gleichflusses bekannt, beispielsweise so genannte" Geomagnetically Induced Currents (GIC) ".

Um in einem Transformator den unerwünschten magnetischen Gleichfluss zu verringern, sind Kompensationseinrichtungen = bekannt. Gesteuert werden diese Kompensationseinrichtungen nach Maßgabe einer Kenngröße, die den magnetischen Gleichfluss abbildet.

Zur Ermittlung einer derartigen Kenngröße wird in der WO 2011/127969 ein von einer Sensorspule umwickelter magnetischer Nebenschluss-Teil vorgeschlagen, der am Joch des Transformators oder an einem von der Wicklung nicht bedeckten Schenkelbereich angeordnet ist.

Nun gibt es Bauformen von Transformatoren, bei denen die Flussaufteilung im Joch bzw. an einer frei zugänglichen Stelle am Kernschenkel wegen der dort herrschenden komplexen Flussaufteilung, die sich je nach Sättigungszustand ändert, als Ort der Messung ungünstig ist. Dies ist bei Transformatoren in einem Leistungsbereich von ab etwa 50 MVA aufwärts der Fall, die üblicher Weise als Fünfschenkelkern-Transformatoren (so genannte 3/2 Kerne) ausgeführt werden.

Bei einem Fünfschenkelkern-Transformator kann die Erfassung eines magnetischen Gleichflusses mittels des oben erwähnten Nebenschluss-Teils von einem Streufluss gestört sein, so dass ein erhöhter Aufwand bei der magnetischen Abschirmung des Streuflusses und/oder bei der elektronischen Auswertung des Sensorsignals erforderlich ist.

Aus der US 5 847 910 A ist eine Messanordnung zum Erfassen eines magnetischen Gleichflusses im Kern eines Transformators bekannt, wobei ein Sensor gebildet aus einem ferromagnetischen Sensorkern , der von einer Sensorspule umwickelt ist, in einem durch die Wicklungsbreite vorgegebenen Abschnitt eines Kernschenkels in einem Ringraum, gebildet aus einer Außenumfangsfläche des Kernschenkels und einer Innenumfangsfläche einer Transformatorwicklung, so angeordnet ist, dass vom Kernschenkel ein magnetischer Teilfluss abgezweigt und über zumindest einen nicht ferromagnetischen Spalt geführt ist.

Die US 2010/194373 A1 zeigt eine Messanordnung zum Erfassen eines magnetischen Gleichflusses im Kern eines Transformators, wobei ein Sensor in einem durch die Wicklungsbreite vorgegebenen Abschnitt eines Kernschenkels in einem Ringraum, gebildet aus einer Außenumfangsfläche des Kern-schenkels und einer Innenumfangsfläche einer Transformator-wicklung, so angeordnet ist, dass vom Kernschenkel ein magnetischer Teilfluss abgezweigt und über zumindest einen nicht ferromagnetischen Spalt geführt ist.

Die US 2013/049751 A1 und die US 3 863 109 offenbaren ebenfalls Messanordnungen zum Erfassen eines magnetischen Gleichflusses im Kern eines Transformators, bei denen ein Sensor gebildet aus einem ferromagnetischen Sensorkern , der von einer Sensorspule umwickelt ist, in einem durch die Wicklungsbreite vorgegebenen Abschnitt eines Kernschenkels in einem Ringraum, gebildet aus einer Außenumfangsfläche des Kernschenkels und einer Innenumfangsfläche einer Transformatorwicklung, so angeordnet ist, dass vom Kernschenkel ein magnetischer Teilfluss abgezweigt und über zumindest einen nicht ferromagnetischen Spalt geführt ist.

### Darstellung der Erfindung

Es ist eine Aufgabe der vorliegenden Erfindung den Stand der Technik weiterzuentwickeln.

Die Lösung der Aufgabe erfolgt durch einen Messanordnung mit den Merkmalen des Anspruchs 1.

Vorteilhafte Ausgestaltungen, Aspekte und Einzelheiten der Erfindung ergeben sich aus den jeweils abhängigen Ansprüchen, der Beschreibung und der beigefügten Zeichnung.

Die Erfindung geht von der Überlegung aus, die Sensorik zur Erfassung des magnetischen Gleichflusses am Kern eines Transformators so anzuordnen, dass der störende Einfluss eines Streuflusses gering ist und die Kenngröße den magnetischen Gleichfluss möglichst gut abbildet.

Gelöst wird dieses Problem durch eine Messeinrichtung zum Erfassen eines magnetischen Gleichflusses im Kern eines Transformators, wobei ein Sensor, gebildet aus einem ferromagnetischen Sensorkern, der von einer Sensorspule umwickelt ist, in einem durch die Wicklungsbreite vorgegebenen Abschnittes eines Kernschenkels in einem Kühlkanal oder in einem Ringraum, gebildet aus einer Außenumfangsfläche des Kernschenkels und einer Innenumfangsfläche der Transformatorwicklung, so angeordnet ist, dass vom Kernschenkel ein magnetischer Teilfluss abgezweigt und über zumindest einen nicht ferromagnetischen Spalt geführt ist.

Durch diese Anordnung des Sensors in einem Kühlkanal oder in einem Zwischenraum, gebildet aus einer Außenumfangsfläche des Kernschenkels und einer Innenumfangsfläche einer zugeordneten Wicklung des Transformators, wird erreicht, dass die Beeinträchtigung des Messsignals durch den magnetischen Streufluss auch bei einem Transformator in Fünfschenkelkern-Bauweise vergleichsweise geringer ist. Eine magnetische Abschirmung ist nicht erforderlich. Die signaltechnische Auswertung des Sensorsignals ist vergleichsweise einfach.

Für die Anordnung des Magnetfeld-Detektors in einem Kühlkanal, bei dem gegenüberliegende Begrenzungsflächen parallel zueinander liegen, erscheint ein flacher Sensorkern günstig. Es kann von Vorteil sein, wenn der Sensorkern die Form eines länglichen Prismas aufweist, dessen Längserstreckung in Richtung der Achse des Kernschenkels gerichtet ist. In einer bevorzugten Ausbildung kann vorgesehen sein, dass das Prisma eine Länge aufweist, die größer ist als eine Breite der Grundfläche des Prismas. Dies begünstigt die Anordnung in einer sich üblicherweise in Schenkelachse erstreckender Kühlkanäle bzw. im Ringraum zwischen Kernschenkel und Wicklung.

Günstige scheint dabei ein Querschnitt des Sensorkerns der an eine vorgegebene Form eines Kühlkanals bzw. an den im Ringraum z.B. durch den Stufenquerschnitt des Kernschenkels vorgegebenen Platzverhältnissen angepasst ist. Grundfläche des Prismas kann ein Polygon sen. Wenn der Strömungsquerschnitt die Form eines Rechtecks aufweist, ist es günstig, wenn die Grundfläche des Sensorkerns ebenfalls ein Rechteck ist.

Üblicherweise erstreckt sich ein Kühlkanal in einem Kernschenkel in axialer Richtung, so dass eine vertikal hängende Anordnung des Sensors vorteilhaft sein kann. In einer bevorzugten Ausführungsform ist also der Sensor mittels einer stabförmigen bzw. leistenförmigen Hängevorrichtung befestigt.

Um die Sensorspule vor mechanischen Einwirkungen zu schützen, kann es vorteilhaft sein, wenn Sensorspule und Sensorkern ein Einlegeteil einer schalenförmigen Hängevorrichtung bilden. Die Befestigung in einer solchen Halbschale kann durch eine Gussmasse oder einen Klebstoff erfolgen.

Eine besonders gute Steifigkeit der leistenförmigen Hängevorrichtung kann durch einen Träger aus einem faserverstärkten Kunststoff erzielt werden. Mit Vorteil kann dabei faserverstärktes Epoxidharz oder Polyesterharz verwendet werden. Selbstverständlich ist es auch möglich, andere Isolationswerkstoffe zu verwenden, beispielsweise temperaturbeständiges Polyamid.

Hinsichtlich der Herstellungskosten kann es günstig sein, wenn Sensorspule und Sensorkern ein so genanntes Kunststoff-Hybridbauteile bilden, welches mit vergleichsweise geringem Aufwand in Spritzgusstechnik herstellbar ist.

Die eingangs gestellte Aufgabe wird auch durch eine Kompensationseinrichtung zum Kompensieren eines magnetischen Gleichflusses in Kern eines Transformators gelöst, wobei ein Sensor den Gleichfluss in zumindest einem Kernschenkel des Transformators erfasst, wobei der Sensor einen sich in einer Längsrichtung erstreckenden ferromagnetischen Sensorkern aufweist, der von einer Sensorspule umwickelt ist. Der Sensor ist in einem durch die Wicklungsbreite vorgegebenen Abschnitt in einem Kühlkanal des Kernschenkels oder in einem Ringraum, gebildet aus einer Außenumfangsfläche des Kernschenkels und einer Innenumfangsfläche der Transformatorwicklung, so angeordnet, dass vom Kernschenkel ein magnetischer Teilfluss abgezweigt und über zumindest einen nicht ferromagnetischen Spalt geführt ist.

Mit einer derartigen Kompensationsvorrichtung ist es möglich auch bei Transformatoren großer Leistung den unerwünschten magnetischen Gleichfluss im Kern weitgehend störungsfrei zu erfassen und wirkungsvoll zu reduzieren bzw. zu kompensieren. Bereits in Betrieb befindliche Fünfschenkelkern-Transformatoren können auf einfache Weise nachgerüstet werden.

Die Erfindung betrifft auch ein Verfahren zum Kompensieren eines magnetischen Gleichflusses in einem magnetischen Kern eines elektrischen Transformators, mit einer Kompensationseinrichtung, der ein Signal eines Sensors zum Erfassen des Gleichflusses zugeleitet wird, wobei der Sensor einen länglich ausgebildeten ferromagnetischen Sensorkern aufweist, der von einer Sensorspule umwickelt ist, wobei der Sensor in seiner Längserstreckung in Richtung der Schenkelachse in einem Kühlkanal oder in einem Ringraum, begrenzt durch die Außenumfangsfläche eines wicklungtragenden Kernschenkels und der Innenumfangsfläche der zugeordneten Transformatorwicklung angeordnet ist.

Dadurch ist auch bei Fünfschenkelkern-Transformatoren eine geräuscharme Betriebsweise möglich. Ein weiterer Vorteil ergibt sich aus der geringeren thermischen Beanspruchung der elektrischen Wicklung, was für die Zuverlässigkeit eines Leistungstransformators günstig ist.

### Kurzbeschreibung der Zeichnung

Zur weiteren Erläuterung der Erfindung wird im nachfolgenden Teil der Beschreibung auf Zeichnungen Bezug genommen, aus denen weitere vorteilhafte Ausgestaltungen, Einzelheiten und Weiterbildungen der Erfindung anhand eines nicht einschränkenden Ausführungsbeispiels zu entnehmen sind.

Es zeigt:
- Figur 1: eine schematische Darstellung eines Sensors zum Erfassen eines magnetischen Gleichflusses im Kern eines Transformators, dargestellt in einer Anordnung in einem Kühlkanal (Figur 1a) oder in einem ringförmigen Zwischenraum zwischen der Schenkelmantelfläche und einer Wicklungs-Innenumfangfläche;
- Figur 2: einen Sensor gemäß Figur 1 dargestellt in einer Dreitafelprojektion und in einer räumlichen Darstellung;
- Figur 3: eine Hängevorrichtung in Form einer Leiste, in welcher der Sensor eine Einlegeteil bildet;
- Figur 4: eine Anordnung des Sensors an einer Seitenfläche eines Schenkelkerns eines symmetrischen Fünfschenkelkern-Drehtransformators;
- Figur 5: eine Anordnung des Sensors in einem Kühlkanal eines Schenkelkerns eines symmetrischen Fünfschenkelkern-Drehtransformators.

### Ausführung der Erfindung

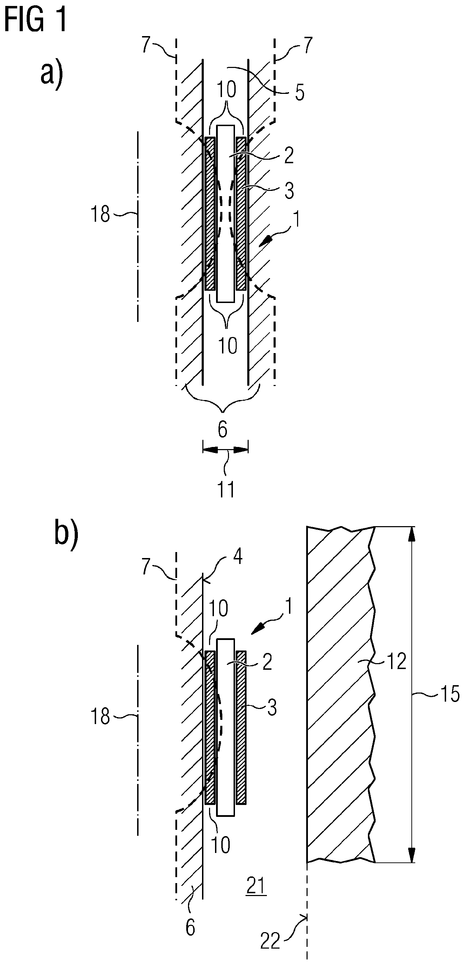

Figur 1 zeigt einen Sensor 1 zum Erfassen eines magnetischen Gleichflusses in einem Kernschenkel 6 eines Transformators. Figur 1a) zeigt eine Anordnung, bei der der Sensor 1 in einem Kühlkanal 5 eines Schenkels 6 in seiner Längserstreckung in Richtung der Schenkelachse 18 angeordnet ist. Figur 1b) zeigt eine andere Anordnung, bei der der Sensor 1 außen an einer Umfangsfläche 4 eines Schenkels 6 anliegend angeordnet ist. Auch in dieser Anordnung ist der Sensor 1 in seiner Längsrichtung in Richtung der Schenkelachse 18 ausgerichtet.

Der Sensor 1 besteht im Wesentlichen aus einem ferromagnetischen Körper, dem Sensorkern 2, der eine Sensorspule 3 trägt. Geometrisch gesehen ist der Sensorkern 2 ein langer, schmaler weichmagnetischer Bauteil hoher Permeabilität, der in seiner bestimmungsgemäßen Einbaulage in seiner Längserstreckung in Richtung der Schenkelachse 18 ausgerichtet ist. Der längliche Sensorkern 2 fungiert dabei in den beiden in Figur 1 dargestellten Anordnungen als magnetischer Nebenschluss-Teil: Sobald der weichmagnetische Werkstoff des Kernschenkels 6 aufgrund der Überlagerung von Gleichfluss und Wechselfluss in seine Sättigung gerät, zweigt der Sensorkern 2 nach Art eines "magnetischen Bypass" einen Teil des im Schenkel geführten magnetischen Fluss 7 ab und führt diesen über zumindest einen nicht ferromagnetischen Spalt 10 wieder zurück in den Kernschenkel 6 (gestrichelte Linie in Figur 1). Mit anderen Worten, bei jeder Halbperiode, bei der das magnetische Material des Schenkelkerns 6 aufgrund des magnetischen Gleichflusses (hervorgerufen durch einen von einem Gleichstrom hervorgerufenen Gleichfluss oder verursacht durch einen so genannten "GIC") in die Sättigung gerät, überbrückt der Sensorkern 2 den von ihm überbrückten Bereich des Schenkels 6 in einem Nebenschluss. In der Sensorspule 3 induziert der abgezweigte Wechselfluss 7, der ein Bruchteil des Schenkel-Hauptflusses ist, eine Sensorspannung 19, welche nach einer signaltechnischen Auswertung als Maß zur Kompensation des magnetischen Gleichflusses herangezogen werden kann.

Die Auswertung kann beispielsweise darin bestehen, dass die Sensorspannung 19 digitalisiert und mittels eines Bandpass-Filters Signalanteile mit doppelter Netzfrequenz herausgefiltert werden und die herausgefilterten Signalwerte einer Fourier-Transformation unterzogen werden. Die anschließende Kompensation des magnetischen Gleichflusses im Kern des Transformators kann beispielsweise durch eine leistungselektronische Einrichtung erfolgen, die in eine an einem Schenkel angeordnete Kompensationswicklung einen Kompensationsstrom einspeist, der von seiner Größe und Richtung den zu kompensieren Gleichfluss entgegen gerichtet ist.

Als Werkstoff für den Sensorkern 2 kommen verschiedene weichmagnetische Werkstoffe infrage. Von Bedeutung ist, dass der Sensorkern 2 hinsichtlich seiner magnetischen Beschaffenheit so beschaffen ist, dass er nicht in die Sättigung gerät, wenn er den vom Schenkel abgezweigten magnetischen Teilfluss führt. Bei entsprechender Ausbildung des nicht ferromagnetischen Spaltes kann Elektroblech verwendet werden, wie es für den Aufbau des Transformators üblich ist.

In der Anordnung der Figur 1a wird im Kühlkanal 5 von beiden Seiten des Kühlkanals 5 ein magnetischer Teilfluss 7 abgezweigt; in der Anordnung der Figur 1b) tritt der abgezweigte Teilfluss 7 aus der Seitenfläche 4 aus und in diese wieder ein (gestrichelte Linie). In der Anordnung der Figur 1b liegt die Sensorspule 3 mit ihrer Flachseite an der Mantelfläche 4 des Kernschenkels 6 an.

In beiden Anordnungen (Figur 1a und Figur 1b) besteht die Sensorspule 3 aus isoliertem Kupferdraht, so dass der von der Spule 3 räumlich beanspruchte Bereich im Kühlkanal 5 nicht ferromagnetisch ist.

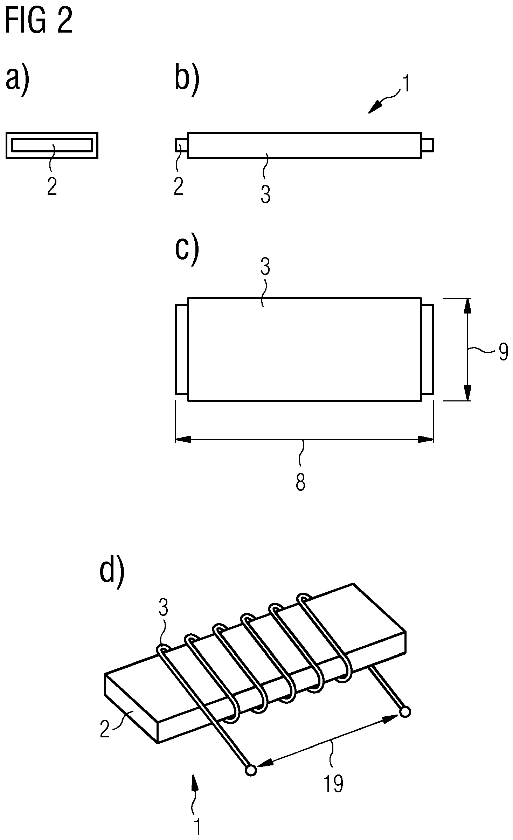

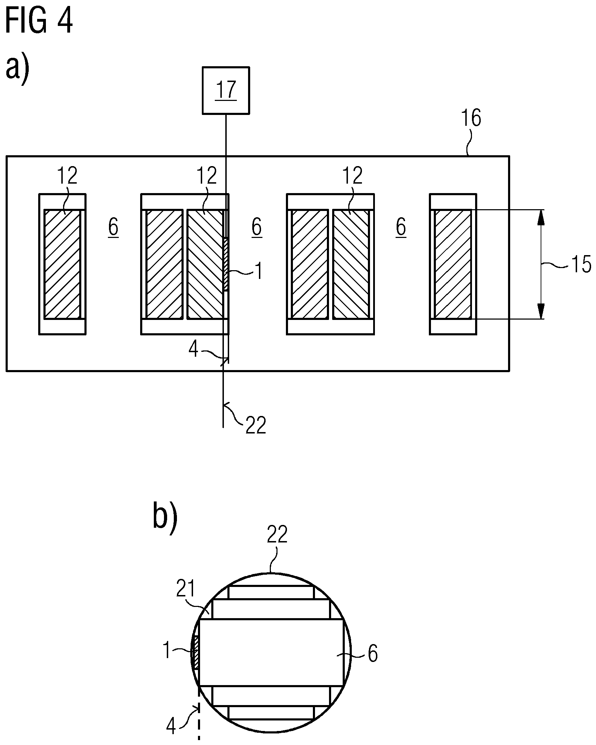

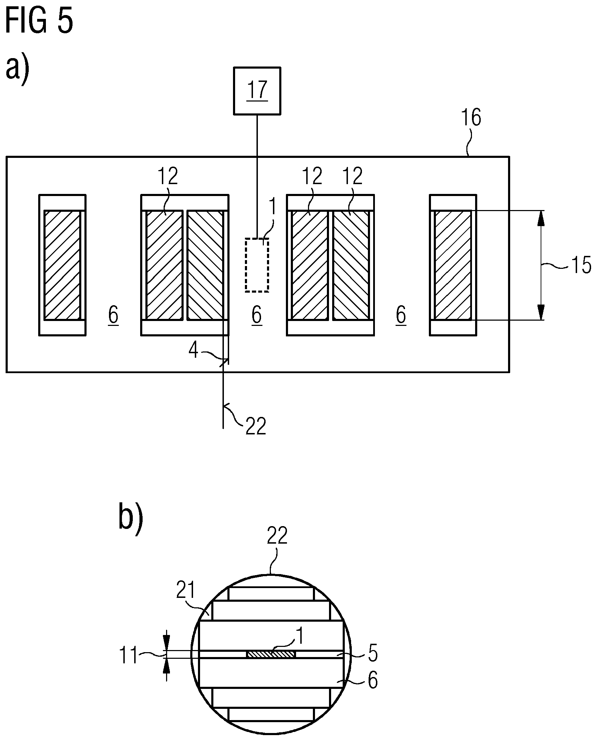

Die Figur 2 zeigt eine bevorzugte Ausführungsform des Sensors 1 in einer Dreitafelansicht. Der Sensor 1 besteht aus einem länglichen Sensorkern 2, in Form eines Prismas. Die Grundfläche des Prismas ist ein Rechteck (Figur 2a). Die Mantelfläche des Prismas ist mit einem elektrischen Leiter aus einem isolierten Kupferdraht umwickelt. In der bestimmungsgemäßen Anordnung des Sensors 1 in einem Kühlkanal 5 oder in einem Ringraum 21 um einen Kernschenkel 6 wird, wie bereits gesagt, durch den abgezweigten Wechsel-Teilfluss 7 in der Sensorspule 3 eine Sensorspannung 19 induziert. Das Signal dieser Sensorspannung 19 ist einer Kompensationseinrichtung 17 (Figur 4 bzw. Figur 5) zugeleitet, mittels derer dem unerwünschten Gleichfluss entgegen gewirkt wird.

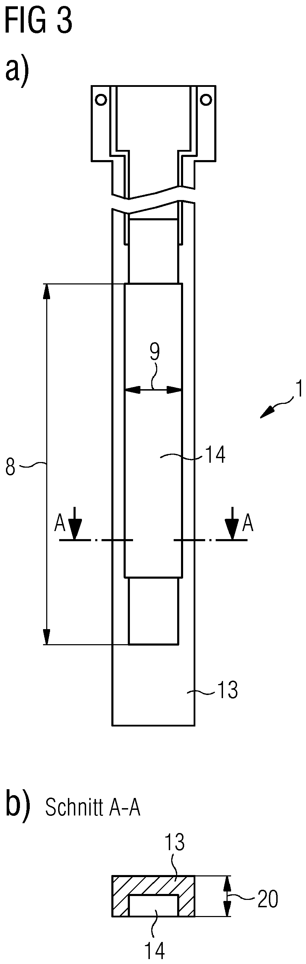

Der Sensor 1 ist in seiner Längserstreckung in Richtung einer Schenkelachse 18 hängend angeordnet. Figur 3 zeigt eine Hängevorrichtung 13 für den Sensor 1 in einem Kühlkanal 5 oder in einem Zwischenraum 21, gebildet durch die Innen-Umfangsfläche einer Transformatorwicklung und einer äußeren Umfangsfläche 4 eines Kernschenkels 6. Die Hängevorrichtung 13 besteht im Wesentlichen aus einem leisten- oder stabförmigen Träger mit einem Kopfteil. Der Kopfteil verhindert, dass der Detektor beim Einbau versehentlich in den Kühlkanal rutscht. Der Träger ist von seinen Abmessungen her weitaus länger als er breit ist. Je nach Größe eines Leistungstransformators kann die axiale Länge des Trägers bzw. des Sensorkerns 2 unterschiedlich sein. Die Länge 8 ist so bemessen, dass die darauf angebrachte Windungszahl der Sensorspule 3 ein gut auswertbares Sensorsignale 19 liefert. Dies wird etwa bei einer Länge 18 von etwa 1 m oder mehr erreicht, wobei die Breite 9 des Sensors 1 etwa einige Zentimeter beträgt. In diesen Dimensionen des Magnetfeld-Sensors ist bei einer Anordnung in einem Kühlkanal 5 die Kühlwirkung wenig beeinträchtigt.

Der Träger der Hängevorrichtung 13 ist aus einem elektrischen Isolator hergestellt, zum Beispiel aus einem temperaturbeständigen und mit dem Kühlmedium des Transformators kompatiblen Polymerstoff. Der Träger weist in seiner Längserstreckung eine schalenförmigen Ausnehmung 14 auf (Figur 3b Schnitt A-A), in welcher der längliche Sensorkern 2 und der darauf befindlichen Sensorspule 3 eingebettet sind. Durch diese Einbettung ist die Sensorspule 3 vor mechanischen Einwirkungen sehr gut geschützt. Unter einem fertigungstechnischen Gesichtspunkt ist eine Ausbildung als Hybridteil günstig, wobei Sensorkern und -spule mit entsprechenden Abstandshaltern in ein Spritzgusswerkzeug eingelegt werden und mit einem Kunststoff, zum Beispiel faserverstärktem Epoxidharz, umspritzt werden.

Bei einer vertikalen Anordnung in einem Kühlkanal 5 entspricht die Dicke 20 des Trägers etwa der Kühlkanalbreite 11. Dadurch ist der ferromagnetischen Spalt 10 zwischen Sensorkern und Schenkel 6 festgelegt. Entsprechendes gilt bei entsprechender Fixierung für eine Anordnung im Ringraum 21 zwischen Wicklung und Seitenfläche des Schenkels 6. Um die Hängevorrichtung 13 im Gehäuse eines Transformators zu befestigen, sind am Kopfteil Bohrungen für Schrauben vorgesehen.

In Figur 4 und Figur 5 ist die Anordnung des Sensors 1 in einem symmetrischen Fünfschenkelkern 16 eines Drehstromtransformators dargestellt. Wie bereits gesagt, ist die Anordnung des Sensors 1 hängend (Figur 4a), entweder in einem Ringraum 21 zwischen Innenumfangsfläche 22 einer innen liegenden Wicklung 12 des Transformators (zum Beispiel Unterspannungswicklung) und einer Außenumfangsfläche 4 des gestuften Kernschenkels 6 (Figur 4b), oder in einem Kühlkanal 5 eines Kernschenkels 6 (Figur 5a und Figur 5b). In Richtung der Schenkelachse 18 gesehen, befindet sich in beiden Anordnungen der Sensor 1 etwa symmetrisch in der Mitte der Wicklungsbreite 15.

Wie in der Zeichnung der Figur 4 bzw. Figur 5 angedeutet, ist das Sensorsignal 19 einer Kompensationseinrichtung 17 zugeleitet, welche den unerwünschten magnetischen Gleichfluss im Kern 16 des Transformators 1 kompensiert, was aber in den Zeichnungen nicht näher dargestellt ist.

Obwohl die Erfindung im Detail durch bevorzugte Ausführungsbeispiele näher illustriert und beschrieben wurde, so ist die Erfindung nicht durch die offenbarten Beispiele eingeschränkt. Andere Variationen können vom Fachmann hieraus abgeleitet werden, ohne den Schutzumfang der Erfindung zu verlassen.

So ist der Sensorkern 1 keineswegs auf die gezeichnete Form eines länglichen Prismas mit rechteckiger Grundfläche eingeschränkt, sondern kann je nach geometrischer Form des Kühlkanals bzw. des zur Verfügung stehenden Zwischenraums zwischen Kernschenkel und Innenumfangsfläche der Transformator-Wicklung einen entsprechend anders gestalteten Querschnitt aufweisen.

Die Länge des Sensorkerns kann auch länger sein als dargestellt, beispielsweise so lang wie die gesamten Wicklungsbreite sein.

In einer kostengünstigen Ausführung kann für den Sensorkern Elektroblech verwendet werden, wie es auch für den Kern des Transformators üblicherweise verwendet wird.

Der Sensorkern kann aus einem Stück Elektroblech oder aus mehreren Lamellen bestehen. Selbst verständlich können auch andere hochpermeable Werkstoffe verwendet werden.

Dank der Erfindung ist es möglich, dass auch bei Transformatoren mit einer Nennleistung von mehreren MVA, die üblicherweise in Fünfschenkelkernbauweise ausgebildet werden, ein magnetischer Gleichfluss zuverlässig erfasst bzw. mit geeigneter Kompensationsvorrichtung effizient kompensiert werden kann.

Durch die wirkungsvolle Kompensation des Gleichflusses ist die Erwärmung geringer, was die Lebensdauer der Isolationswerkstoffe der Wicklung begünstigt.

Ein weiterer wesentlicher Vorteil ist darin zu sehen, dass Betriebsgeräusche eine Leistungstransformators wirkungsvoll reduziert werden.

Die Herstellung des Sensors ist einfach und erfüllt die Anforderungen hinsichtlich Zuverlässigkeit und Langlebigkeit, die bei Leistungstransformatoren gefordert werden. Die Herstellungskosten sind gering.

Die Messanordnung kann auch für Monitoring eingesetzt werden.

Ein weiterer Vorteil ist das einfache Nachrüsten, Umrüsten sowie Modernisieren bestehender Leistungstransformatoren.

Zusammenstellung der verwendeten Bezugszeichen
- 1: Sensor
- 2: Sensorkern
- 3: Sensorspule
- 4: Außenumfangsfläche
- 5: Kühlkanal
- 6: Kernschenkel
- 7: Teilfluss
- 8: Sensorlänge
- 9: Sensorbreite
- 10: Spalt
- 11: Kühlkanal-Breite
- 12: Wicklung
- 13: Hängevorrichtung
- 14: Ausnehmung
- 15: Wicklungshöhe
- 16: Kern
- 17: Kompensationseinrichtung
- 18: Schenkelachse
- 19: Sensorsignal
- 20: Breite des Trägers der Hängevorrichtung
- 21: Ringraum
- 22: Innenumfangsfläche

## Patentansprüche

1. Messanordnung zum Erfassen eines magnetischen Gleichflusses im Kern eines Transformators, wobei ein Sensor (1), gebildet aus einem ferromagnetischen Sensorkern (2), der von einer Sensorspule (3) umwickelt ist, in einem durch die Wicklungsbreite (15) vorgegebenen Abschnitt eines Kernschenkels (6) in einem Kühlkanal (5) oder in einem Ringraum (21), gebildet aus einer Außenumfangsfläche (4) des Kernschenkels (6) und einer Innenumfangsfläche (22) einer Transformatorwicklung (12), so angeordnet ist, dass vom Kernschenkel (6) ein magnetischer Teilfluss (7) abgezweigt und über zumindest einen nicht ferromagnetischen Spalt (10) geführt ist, wobei der Sensorkern (2) die Form eines sich in einer Längsrichtung erstreckenden Prismas aufweist, wobei in bestimmungsgemäßer Verwendung des Sensors (1) die Längsrichtung in Richtung der Schenkelachse (18) ausgerichtet ist, **dadurch gekennzeichnet, dass** Sensorkern (2) und Sensorspule (3) zusammen als Einlegeteil in einer leistenförmigen Hängevorrichtung (13) ausgebildet sind und dass die Hängevorrichtung (13) einen Träger aus einem faserverstärkten Kunststoff aufweist, wobei der Träger eine länglich sich erstreckende schalenförmige Ausnehmung (14) zur Aufnahme des Sensors (1) aufweist.

2. Messanordnung nach Anspruch 1, **dadurch gekennzeichnet, dass** der Sensor (1) und der Träger ein Kunststoff-Hybridbauteil bilden, welches in Spritzgusstechnik hergestellt ist.

## Claims

1. Measuring arrangement for detecting a magnetic unidirectional flux in the core of a transformer, wherein a sensor (1), formed from a ferromagnetic sensor core (2) which is enwound by a sensor coil (3), is arranged in a section of a core limb (6), said section being predetermined by the winding width (15), in a cooling channel (5) or in an annular space (21) which is formed by an outer peripheral surface (4) of the core limb (6) and an inner peripheral surface (22) of a transformer winding (12), in such a manner that a magnetic partial flux (7) is diverted from the core limb (6) and guided over at least one non-ferromagnetic gap (10), wherein the sensor core (2) has the shape of a prism which extends in a longitudinal direction, wherein the longitudinal direction is oriented in the direction of the limb axis (18) when the sensor (1) is used as intended, **characterised in that** sensor core (2) and sensor coil (3) are developed together as an insert in a bar-shaped suspension device (13) and that the suspension device (13) has a carrier which is made of a fibrereinforced synthetic material, wherein the carrier has a longitudinally extending shell-like recess (14) for receiving the sensor (1).

2. Measuring arrangement according to claim 1, **characterised in that** the sensor (1) and the carrier form a hybrid component, made of a synthetic material, which is manufactured using injection moulding technology.

## Revendications

1. Dispositif de mesure pour la saisie d'un flux magnétique continu dans le noyau d'un transformateur, dans lequel un capteur (1), constitué par un noyau de capteur ferromagnétique (2) enroulé par une bobine de capteur (3), est disposée de telle manière dans une section d'une branche du noyau (6) établie par la largeur du bobinage (15), dans un conduit de refroidissement (5) ou dans un espace annulaire (21), constitué par une surface périphérique externe (4) de la branche du noyau (6) et une surface périphérique interne (22) d'un bobinage du transformateur (12), qu'un flux magnétique partiel (7) est dévié de la branche du noyau (6) et mené à travers au moins une fente non ferromagnétique (10), dans lequel le noyau de capteur (2) présente la forme d'un prisme s'étendant dans un sens longitudinal, dans lequel en présence d'une utilisation conforme du capteur (1), le sens longitudinal est dirigé vers l'axe de la branche (18), **caractérisé en ce que** le noyau de capteur (2) et la bobine de capteur (3) sont exécutées ensemble sous forme de pièce d'insertion dans un dispositif de suspension (13) en forme de listeau et **en ce que** le dispositif de suspension (13) présente un support en un plastique renforcé en fibres, dans lequel le support présente un évidement (14) en forme de coupe s'étendant longitudinalement afin d'accueillir le capteur(1).

2. Dispositif de mesure selon la revendication 1, **caractérisé en ce que** le capteur (1) et le support constituent un composant hydride en plastique fabriqué selon la technique du moulage par injection.
